# EUROPEAN PATENT SPECIFICATION

(11) **EP 4 068 926 B1**
(45) Date of publication and mention of the grant of the patent: **03.12.2025**
(21) Application number: 21306171.6
(22) Date of filing: 30.08.2021
(51) Int. Cl.: H05K 7/20, G06F 1/20

(54) **HYBRID IMMERSION COOLING SYSTEM FOR RACK-MOUNTED ELECTRONIC ASSEMBLIES**
HYBRIDES TAUCHKÜHLSYSTEM FÜR RACKMONTIERTE ELEKTRONISCHE BAUGRUPPEN
SYSTÈME HYBRIDE DE REFROIDISSEMENT PAR IMMERSION POUR ENSEMBLES ÉLECTRONIQUES MONTÉS SUR BÂTI

(30) Priority: 01.04.2021 EP 21305427
(43) Date of publication of application: 05.10.2022
(73) Proprietor: OVH, 59100 Roubaix (FR)
(72) Inventor: HNAYNO, Mohamad, 59100 Roubaix (FR); CHEHADE, Ali, 59283 Moncheaux (FR); KLABA, Henryk, 59100 Roubaix (FR)
(74) Representative: BCF Global

(56) References cited:
- WO-A1-2020/234600
- WO-A2-2019/068916
- US-A1- 2018 027 695
- US-A1- 2018 338 388

## Description

### CROSS-REFERENCE TO RELATED APPLICATIONS

This application claims benefit to European Application No. EP 21305427, entitled "IMMERSION COOLING CONCEPTS FOR SERVERS", filed on April 1, 2021.

### FIELD

The present disclosure generally relates to the cooling of rack-mounted electronic equipment and, in particular, to a hybrid liquid cooling system for such equipment.

### BACKGROUND

Electronic equipment such as, for example, processing servers, memory storage systems, *etc.* are typically arranged in equipment racks. Large computing facilities servicing the increased demand for processing resources may contain thousands of racks to support such electronic equipment.

Such electronic equipment racks, including support equipment mounted on their backplanes, consume large amounts of electric power for proper operations which, in turn, results in the generation of substantial amounts of heat. For example, certain components of electronic assemblies, such as, processing units, generate so much heat during operations that they are susceptible to failure within seconds without adequate cooling. Accordingly, cooling measures/techniques are of particular import to electronic equipment racks.

In conventional implementations, fans are mounted within the electronic equipment racks to provide forced-air cooling to the rack-mounted equipment housing electronic assemblies. However, this implementation merely displaces some of the heat generated within the rack-mounted equipment to the general ambient environment which, in turn, requires further ambient cooling measures.

Recently, liquid cooling methods have been introduced as an addition and/or alternative to conventional fan forced-air cooling of electronic equipment racks. One such method is a direct cooling plate block technique that comprises cooling plate blocks having internal channels for circulating cooled water that are directly mounted to heat-generating electronic components, such as processing units, to displace the heat generated therefrom towards mounted heat-exchanging units. In turn, the mounted heat-exchanging units may employ finned tubes or plate structures having relatively large surface areas to adequately displace heat (*e.g.,* in similar fashion to radiators) away from the electronic components.

Another liquid cooling method is an immersion cooling technique, in which electronic components are fully submerged in a casing containing a non-conductive cooling liquid, such as, for example, an oil-based dielectric cooling liquid. The immersion of the electronic components achieves adequate thermal contact between the electronic components and the dielectric cooling liquid. However, certain electronic components, such as, for example, processing units tend to generate more heat than other devices, such as, for example, memory boards.

As such, the immersion cooling technique generally requires circulation of the dielectric cooling liquid within the casing that is maintained at a lower temperature level sufficient to cool the hotter generating electronic components. To do so, the immersion cooling technique typically employs pumps, heat sink structures, heat exchangers, sealed evaporative equipment, *etc.* that either consume large amounts of energy to operate, require sealed casings with environmentally unfriendly chemicals, or occupy relatively large surface areas that limit the number of electronic components that can be implemented.

Document WO 2020/234600 discloses a system and a method for cooling a plurality of electronic devices housed in a housing of an electronic module. Document WO 2019/068916 discloses a thermal energy distribution assembly arranged for transferring thermal energy away from a computer system.

Even though the recent developments noted above have shown to provide some limited benefits, improvements are still desirable in achieving higher efficiencies and increasing the overall cooling performance of rack-mounted liquid-cooled electronic assemblies.

The subject matter discussed in the background section should not be assumed to be prior art merely as a result of its mention in the background section. Similarly, a problem mentioned in the background section or associated with the subject matter of the background section should not be assumed to have been previously recognized in the prior art.

### SUMMARY

The embodiments of the present disclosure are provided based on developers' understanding of the limitations associated with the prior art, in achieving higher efficiencies, increasing the overall cooling performance of rack-mounted liquid-cooled electronic assemblies, and improving the power consumption of such electronic assemblies.

In addressing such limitations, the claimed invention provides a rack-mounted hybrid liquid cooling system **(100)** as defined in claim 1.

The hybrid liquid cooling system **(100)** also comprises one or more fluid cooling blocks **(110A, 112A)** arranged to be in direct thermal contact with the one or more heat-generating electronic processing components (**110**, **112**), the one or more fluid cooling blocks **(110A, 112A)** fluidly-coupled to the closed-loop fluid distribution arrangement **(134)** and configured to cool the one or more heat-generating electronic processing components **(110, 112)** based on the lower-temperature channelized fluid forwarded by the cooling module **(130)** via the closed-loop fluid distribution arrangement **(134).**

The closed-loop fluid distribution arrangement **(134)** of the hybrid liquid cooling system **(100)** comprises a tube channel network **(136)** configured to facilitate the circulation of channelized fluid between the fluidly-coupled serpentine convection coil **(120),** the fluidly-coupled one or more fluid cooling blocks **(110A, 112A),** and the fluidly-coupled external cooling module **(130).** The tube channel network may be constructed from flexible materials (*e.g.,* rubber, plastic, *etc*.), rigid materials (*e.g.,* metal, PVC piping, *etc*.)*,* or any combination of such materials.

In certain implementations consistent with the present disclosure, the tube channel network **(136)** is structured to route the lower-temperature channelized fluid from the external cooling module **(130)** to at least one fluid cooling block **(110A)** and route a resulting higher-temperature channelized fluid output from the at least one cooling block (**112A**) to the upper port of the serpentine convection coil **(120),** wherein the lower port of the serpentine convection coil **(120)** forwards the higher-temperature channelized fluid to the external cooling module **(130)** for thermal conditioning into the lower-temperature channelized fluid.

In certain implementations consistent with the present disclosure, the tube channel network **(136)** is structured to route the lower-temperature channelized fluid from the external cooling module **(130)** to at least one fluid cooling block **(110A)** and route a resulting higher-temperature channelized fluid output from the at least one fluid cooling block **(110A)** to the lower port of the serpentine convection coil **(120),** wherein the upper port of the serpentine convection coil **(120)** forwards the higher-temperature channelized fluid to the external cooling module **(130)** for thermal conditioning into the lower-temperature channelized fluid.

In certain implementations consistent with the present disclosure, the tube channel network **(136)** is structured to route the lower-temperature channelized fluid from the external cooling module **(130)** to the lower port of the serpentine convection coil **(120)** and route the lower-temperature channelized fluid from the upper port of the serpentine convection coil **(120)** to at least one fluid cooling block **(110A),** wherein a resulting higher-temperature channelized fluid output from the at least one fluid cooling block **(110A)** is forwarded to the external cooling module **(130)** for thermal conditioning into the lower-temperature channelized fluid.

In certain implementations consistent with the present disclosure, the tube channel network **(136)** is structured to route the lower-temperature channelized fluid from the external cooling module **(130)** to the upper port of the serpentine convection coil **(120)** and route the lower-temperature channelized fluid from the lower portion port of the serpentine convection coil **(120)** to at least one fluid cooling block **(110A),** wherein a resulting higher-temperature channelized fluid output from the at least one fluid cooling block **(110A)** is forwarded to the external cooling module **(130)** for thermal conditioning into the lower-temperature channelized fluid.

In the context of the present specification, unless expressly provided otherwise, the expression "computer-readable medium" and "memory" are intended to include media of any nature and kind whatsoever, non-limiting examples of which include RAM, ROM, disks (CD-ROMs, DVDs, floppy disks, hard disk drives, etc.), USB keys, flash memory cards, solid state-drives, and tape drives. Still in the context of the present specification, "a" computer-readable medium and "the" computer-readable medium should not be construed as being the same computer-readable medium. To the contrary, and whenever appropriate, "a" computer-readable medium and "the" computer-readable medium may also be construed as a first computer-readable medium and a second computer-readable medium.

In the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

Implementations of the present technology each have at least one of the above-mentioned object and/or aspects, but do not necessarily have all of them, with the invention being defined by the appended claims.

It should be understood that some aspects of the present technology that have resulted from attempting to attain the above-mentioned object may not satisfy this object and/or may satisfy other objects not specifically recited herein.

Additional and/or alternative features, aspects and advantages of implementations of the present technology will become apparent from the following description, the accompanying drawings and the appended claims.

### BRIEF DESCRIPTION OF THE FIGURES

Further features and advantages of the present disclosure will become apparent from the following detailed description, taken in combination with the appended drawings, in which:
FIG. 1 is a conceptual block diagram of a hybrid liquid cooling system, which is not in accordance with the claimed invention;
FIG. 2 is a functional block diagram of a hybrid liquid cooling system implementation, in accordance with the embodiments of the present disclosure;
FIG. 3 is a functional block diagram of another hybrid liquid cooling system implementation, in accordance with the embodiments of the present disclosure;
FIG. 4 is a functional block diagram of yet another hybrid liquid cooling system implementation, in accordance with the embodiments of the present disclosure;
FIG. 5 is a functional block diagram of an additional hybrid liquid cooling system implementation, in accordance with the embodiments of the present disclosure; and
FIGs. 6, 7 are conceptual views of a hybrid liquid cooling system containing multiple serpentine convection coils, in accordance with the embodiments of the present disclosure.

### DETAILED DESCRIPTION

The instant disclosure is directed to address at least some of the deficiencies of the current technology. In particular, the instant disclosure presents a hybrid liquid-cooling system for at least one rack-mounted immersion case containing at least one electronic assembly submerged in dielectric immersion cooling liquid.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

With these fundamentals in place, we will now consider some non-limiting examples to illustrate various implementations of aspects of the present disclosure.

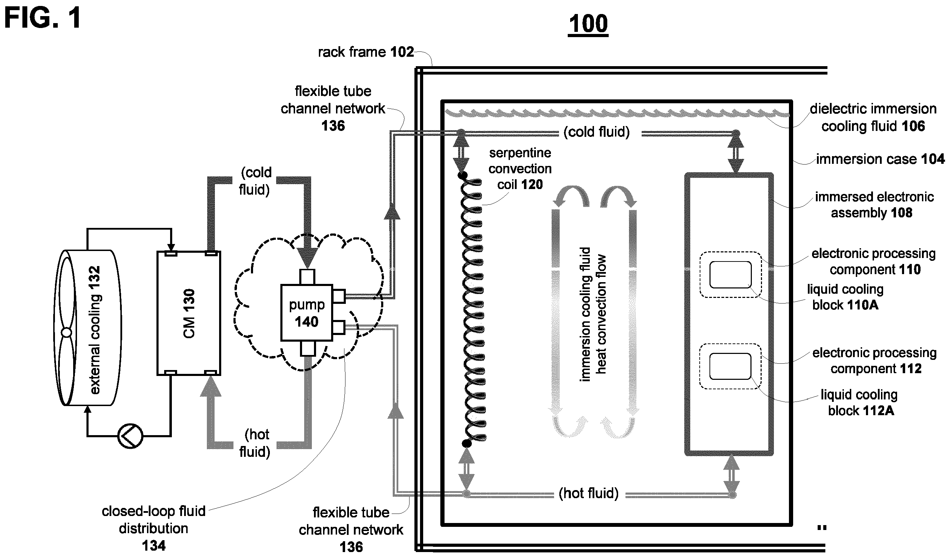

In particular, FIG. 1 depicts a conceptual block diagram of a hybrid liquid cooling system 100, which is not in accordance with the claimed invention.

The hybrid liquid-cooling system **100** is configured to provide a novel integration of specific immersion-cooling and direct channelized liquid-cooling fluid techniques.

With this said, FIG. 1 shows that hybrid liquid-cooling system **100** comprises a rack frame **102** that houses at least one rack-mounted immersion case **104** containing a volume of non-conductive dielectric immersion fluid **106** and at least one electronic assembly **108** that is submerged in the dielectric immersion cooling liquid **106.**

For illustrative purposes and ease of understanding only, the figures depict a single rack-mounted immersion case **104** and a single electronic assembly **108.** Such depictions should not be interpreted as being limiting, as the inventive concepts presented herein cover and contemplate the use of multiple immersion cases **104** and/or multiple electronic assemblies **108.**

By having electronic assembly **108** submerged in the dielectric immersion cooling liquid **106,** rack-mounted immersion case **104** provides immersion-cooling of electronic assembly **108.** Specifically, submerged electronic assembly **108** may contain processing, RAM, ROM, hard disk drives, *etc.* components. By being submerged, the electronic assembly **108** components are arranged to come in direct contact with the dielectric immersion cooling liquid **106,** thereby effectively reducing the operating temperatures of such components.

The rack-mounted immersion case **104** may also contain a serpentine convection coil **110** that is also submerged within the dielectric immersion cooling liquid **106.** The serpentine convection coil **110** is structured with multiple hollow-channel coils to provide a high surface area exposure relative to the dielectric immersion cooling liquid **106** while also maintaining compact overall length and width dimensions. The serpentine convection coil **110** is also structured with a fluidly-coupled upper port and a fluidly-coupled lower port.

With this structure, serpentine convection coil **110** is configured to cool the ambient temperature and induce thermal convection in the the dielectric immersion cooling liquid **106** through direct channelized liquid-cooling. That is, serpentine convection coil **110** internally conveys a circulating channelized cooling fluid that operates to cool the dielectric immersion cooling liquid **106.** It is to be understood that the channelized cooling fluid may consist of a different liquid from the dielectric immersion cooling liquid **106.** That is, the channelized cooling fluid may comprise water, alcohol, or any suitable liquid capable of sustaining adequate cooling temperatures.

Moreover, in an effort to optimize the thermal convection flow of the dielectric immersion cooling liquid **106,** serpentine convection coil **120** may be strategically positioned separate from electronic assembly **108** while in an area within immersion case **104** approximate to the relative locations of heat-generating components **110, 112** associated with electronic assembly **108.**

As noted above, electronic assembly **108** comprises electronic components that are also submerged within dielectric immersion cooling liquid **106.** In many implementations, at least one of the electronic components may comprise a heat-generating electronic processing component **110, 112.** Such electronic processing heat-generating components **110, 112** may take the form of general processing units and/or specialized processing units. Examples of such processing units include, but are not limited to, central processing units (CPUs), graphics processing units (GPUs), neural processing units (NPUs), tensor processing units (TPUs), power supply circuitry, and application specific integrated circuits (ASICs), including, for example, ASICs configured for high-speed cryptocurrency mining.

In order to provide further cooling to these particularly heat-generating electronic processing components **110, 112,** and as a supplement to the overall immersion cooling of electronic assembly **108** within rack-mounted immersion case **104,** direct channelized liquid-cooling fluid may be implemented. That is, cooling blocks **110A, 112A** may be arranged to be in direct thermal contact with the one or more heat-generating electronic processing components **110, 112.** The fluid cooling blocks **110A, 112A** are structured to convey the circulating channelized cooling fluid to provide additional cooling measures to heat-generating electronic processing components **110, 112.**

Turning back to FIG. 1, hybrid liquid cooling system **100** further comprises a closed-loop fluid distribution arrangement **134.** The closed-loop fluid distribution arrangement **134** operates to circulate lower temperature ("cool") channelized fluid, *e.g.* 30°-45°C, to components within the immersion case **104** and commensurately circulate higher temperature ("hot") channelized fluid , *e.g.* ≥ 50°C, back from those components. To this end, closed-loop fluid distribution arrangement **134** is structured with a tube channel network **136** arranged to provide the overall distribution and circulation of "cool" and "hot" channelized fluid to and from fluidly-coupled components within rack-mounted immersion case **104.**

As shown, closed-loop fluid distribution arrangement **134** is fluidly-coupled to an external cooling module CM **130.** The cooling module CM **130** is configured to thermally condition the higher temperature "hot" channelized fluid received from the fluidly-coupled components within rack-mounted immersion case **104,** via tube channel network **136,** into lower-temperature "cool" channelized fluid. The cooling module CM **130** is further configured to forward the conditioned lower-temperature "cool" channelized fluid to the fluidly-coupled components, via tube channel network **136.**

As also shown, cooling module CM **130** is configured to fluidly communicate with an external cooling source **132** that operates to supply cooling module CM **130** with lower temperature fluid flow to facilitate the thermal conditioning by the external cooling module **130** of the higher-temperature channelized fluid into the lower-temperature channelized fluid. The external cooling source **132** may comprise an external cool water supply, a dry cooling unit, or any other suitable measure capable of providing adequate cooling temperature fluid flow to external cooling module **130** for proper thermal conditioning operations by external cooling module **130.**

In addition, closed-loop fluid distribution arrangement **134** comprises at least one pump **140** that is fluidly-coupled to the external cooling module CM **130** to provide an adequate circulatory flow rate, *e.g.,* 0.35-0.55 liters/min. In particular, pump **140** is configured to receive the higher-temperature "hot" channelized fluid from the higher temperature "hot" channelized fluid received from the fluidly-coupled components, such as, serpentine convection coil **110** and fluid cooling blocks **110A, 112A** within rack-mounted immersion case **104,** via tube channel network **136,** and forward the "hot" channelized fluid to cooling module CM **130** for lower temperature conditioning.

The pump **140** is also configured to receive the conditioned lower temperature "cool" channelized fluid from cooling module CM **130** and forward, via tube channel network **136,** the "cool" channelized fluid to the fluidly-coupled components within rack-mounted immersion case **104,** such as, serpentine convection coil **110** and fluid cooling blocks **110A, 112A**.

Therefore, the infrastructure of hybrid liquid-cooling system **100** described above provides for the circulation of lower-temperature "cool" channelized fluid from the external cooling module **130** to the fluidly-coupled serpentine convection coil **120** and/or the fluidly-coupled one or more fluid cooling blocks **110A, 112A** for component cooling operations as well as the circulation higher-temperature "hot" channelized fluid from the fluidly-coupled serpentine convection coil **120** and/or the fluidly-coupled one or more fluid cooling blocks **110A, 112A** back to the external cooling module **130** for conditioning into lower-temperature channelized fluid.

By virtue of the infrastructure, hybrid liquid-cooling system **100** is capable of maintaining a relatively narrow thermal variance between the input "cool" channelized fluid and the output "hot" channelized fluid of ΔT = 20K as well as achieving a rack cooling partial Power Use Effectiveness (pPUE) equal to 1.00.

Given the overall hybrid liquid-cooling system **100** concept of integrating specific immersion-cooling and direct channelized liquid-cooling fluid techniques as presented above, the following descriptions detail various non-limiting implementations of the hybrid liquid-cooling system **100** that generally embody the disclosed concepts.

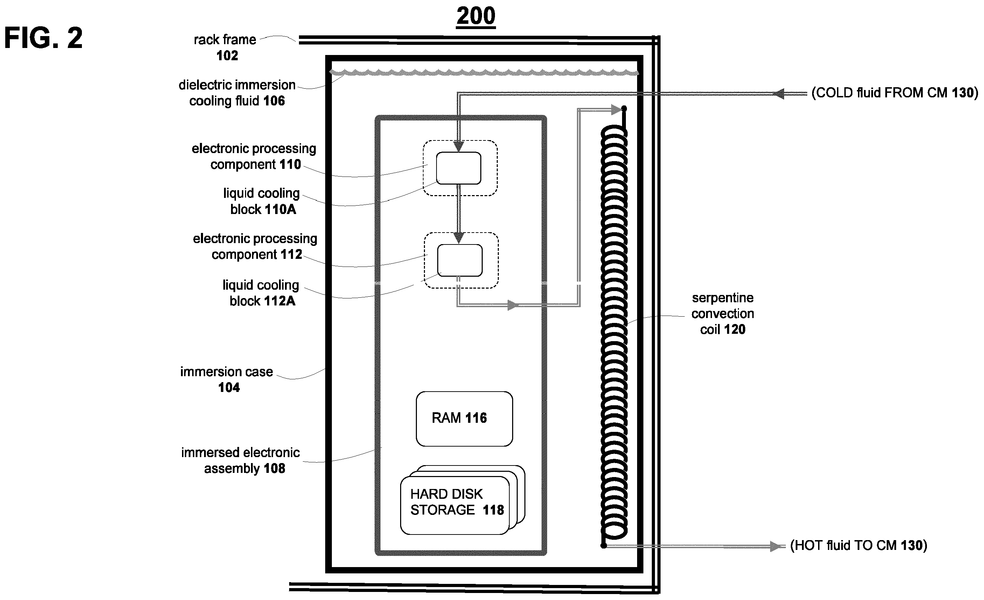

FIG. 2 is a functional block diagram of a hybrid liquid cooling system implementation **200,** in accordance with the embodiments of the present disclosure. FIG. 2 illustrates similar structural features as FIG. 1, so identical reference characters are used and the previous descriptions of such features and attributes are omitted for purposes of brevity.

FIG. 2 depicts hybrid liquid-cooling system implementation **200** that is configured to provide both the immersion-cooling and direct channelized liquid-cooling fluid techniques described above. The particular configuration of implementation **200** offers one solution for optimizing the liquid cooling of submerged components. Specifically, hybrid liquid-cooling system implementation **200** comprises immersion case **104** containing a volume of dielectric immersion fluid **106,** submerged electronic assembly **108** having heat-generating electronic processing components **110, 112,** and submerged serpentine convection coil **120.**

In the hybrid liquid-cooling system implementation **200,** the tube channel network **136** is structured to route the lower-temperature "cool" channelized fluid from the external cooling module **130** to at least one fluid cooling block **110A**. The resulting higher-temperature "hot" channelized fluid output from the at least one cooling block **110A** is then routed to the upper port of the serpentine convection coil **120.** The lower port of the serpentine convection coil **(120)** subsequently forwards the higher-temperature channelized fluid to the external cooling module **(130)** for thermal conditioning and conversion into the lower-temperature channelized fluid.

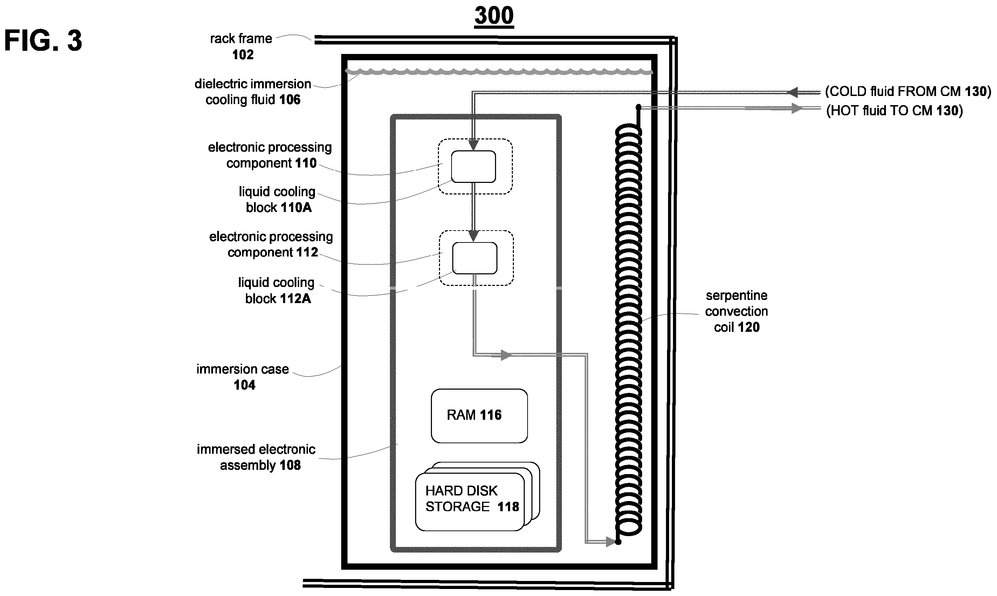

FIG. 3 depicts hybrid liquid-cooling system implementation **300** that is also configured to provide both the immersion-cooling and direct channelized liquid-cooling fluid techniques described above. The particular configuration of implementation **300** offers another solution for optimizing the liquid cooling of submerged components.

Like implementation **200,** hybrid liquid-cooling system implementation **300** comprises immersion case **104** containing a volume of dielectric immersion fluid **106,** submerged electronic assembly **108** having heat-generating electronic processing components **110, 112,** and submerged serpentine convection coil **120.** However, in hybrid liquid-cooling system implementation **300,** the tube channel network **136** is structured to route the lower-temperature "cool" channelized fluid from the external cooling module **130** to at least one fluid cooling block **110A**. The resulting higher-temperature "hot" channelized fluid output from the fluid cooling block **110A** is then routed to the lower port of the serpentine convection coil **120.** The upper port of the serpentine convection coil **120** subsequently forwards the higher-temperature channelized fluid to the external cooling module **130** for thermal conditioning/conversion into the lower-temperature channelized fluid.

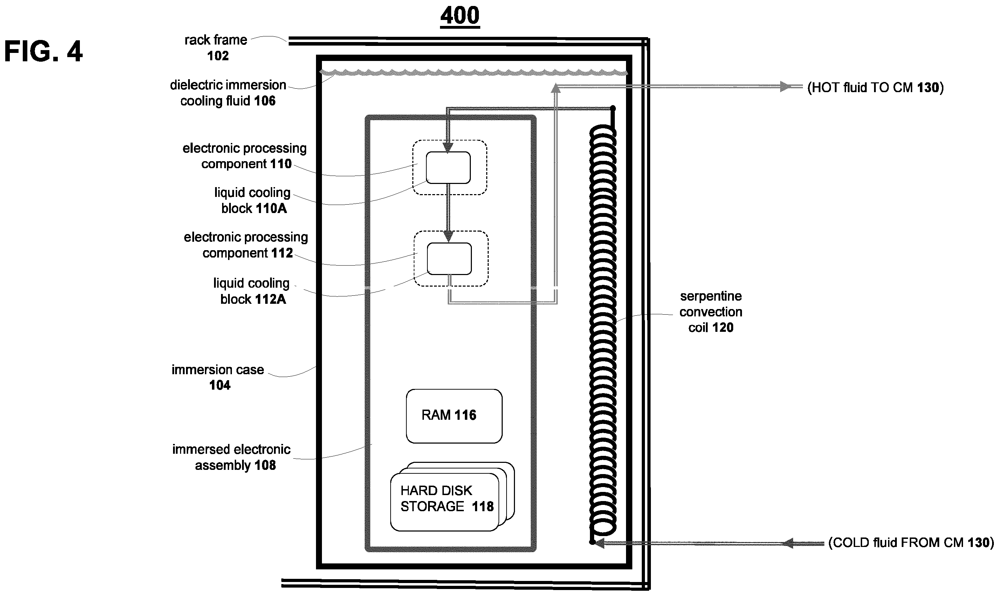

FIG. 4 depicts hybrid liquid-cooling system implementation **400** that is also configured to provide both the immersion-cooling and direct channelized liquid-cooling fluid techniques described above. The particular configuration of implementation **400** offers another solution for optimizing the liquid cooling of submerged components.

Like implementations **200, 300** hybrid liquid-cooling system implementation **400** comprises immersion case **104** containing a volume of dielectric immersion fluid **106,** submerged electronic assembly **108** having heat-generating electronic processing components **110, 112,** and submerged serpentine convection coil **120.** However, in hybrid liquid-cooling system implementation **400,** the tube channel network **136** is structured to route the lower-temperature "cool" channelized fluid from the external cooling module **130** to the lower port of the serpentine convection coil **120.** The lower-temperature channelized fluid is then routed from the upper port of the serpentine convection coil **120** to at least one fluid cooling block **110A**. The resulting higher-temperature "hot" channelized fluid output from the fluid cooling block **110A** is subsequently forwarded to the external cooling module **130** for thermal conditioning/conversion into the lower-temperature channelized fluid.

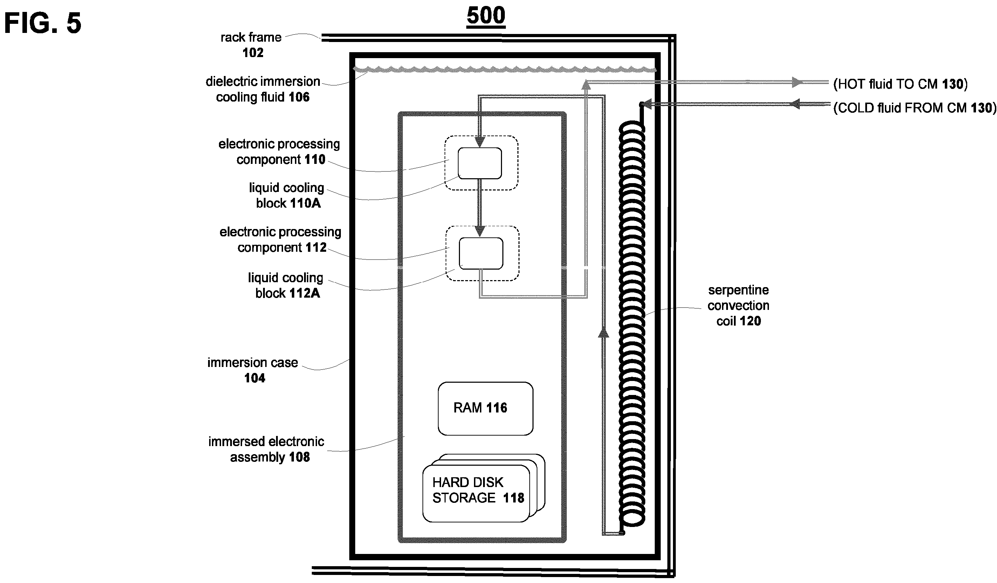

FIG. 5 depicts hybrid liquid-cooling system implementation **500** that is also configured to provide both the immersion-cooling and direct channelized liquid-cooling fluid techniques described above. The particular configuration of implementation **500** offers yet another solution for optimizing the liquid cooling of submerged components.

Like implementations **200, 300, 400** hybrid liquid-cooling system implementation **500** comprises immersion case **104** containing a volume of dielectric immersion fluid **106,** submerged electronic assembly **108** having heat-generating electronic processing components **110, 112,** and submerged serpentine convection coil **120.** However, in hybrid liquid-cooling system implementation **500,** the tube channel network **136** is structured to route the lower-temperature "cool" channelized fluid from the external cooling module **130** to the upper port of the serpentine convection coil **120.** The lower-temperature channelized fluid from the lower portion port of the serpentine convection coil **120** is then routed to at least one fluid cooling block **110A.** The resulting higher-temperature "hot" channelized fluid output from the fluid cooling block **110A** is subsequently forwarded to the external cooling module **130** for thermal conditioning/conversion into the lower-temperature channelized fluid.

It will be appreciated that hybrid liquid-cooling system implementations **200, 300, 400, 500** may comprise more than one fluid cooling block **110A.** That is, as shown, implementations **200, 300, 400, 500** may comprise first fluid cooling block **110A** and a second fluid cooling block **112A** that are fluidly-coupled in series with each other to maintain the closed-loop connectivity of closed-loop fluid distribution arrangement **134.**

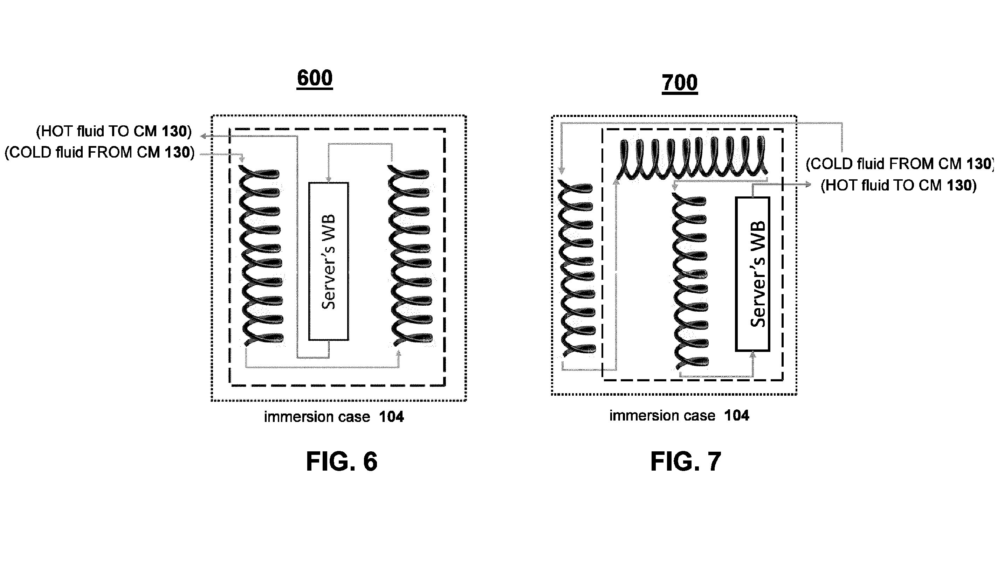

It is contemplated that some operational environments and equipment implementations may require additional immersion cooling measures. Accordingly, FIGs. 6, 7 provide conceptual views of a hybrid liquid cooling system containing multiple serpentine convection coils, in accordance with the embodiments of the present disclosure. As shown, FIGs. 6, 7 indicate the respective routing of the channelized liquid-cooling fluid to and from cooling module **130** and between the serpentine coils to maintain the closed-loop connectivity of closed-loop fluid distribution arrangement **134.**

It is further contemplated that the infrastructure of hybrid liquid-cooling system implementations **200, 300, 400, 500** allows for hot water recycling measures by repurposing the higher-temperature channelized fluid to assist in the operations of other heat generating mechanisms, such as, for example, boilers, engine cogeneration, carbon filter plants, *etc.*

## Claims

1. A rack-mounted hybrid liquid cooling system **(100),** comprising at least one immersion case **(104)** mounted to a rack frame (102) and containing a volume of dielectric immersion cooling liquid**(106)** and at least one electronic assembly **(108)** comprising one or more heat-generating electronic processing component **(110, 112)** submerged in the dielectric immersion cooling liquid **(106);**
a closed-loop fluid distribution arrangement (134) configured to circulate a channelized fluid to and from a serpentine convection coil (120) submerged within the dielectric immersion cooling liquid and one or more fluid cooling blocks **(110A, 112A)** in direct thermal contact with said heat-generating electronic processing components **(110, 112)** submerged within the rack-mounted immersion casing (104), the closed-loop fluid distribution arrangement (134) comprising a tube channel network (136);
an external cooling module (130) configured to thermally condition the channelized fluid circulated by the closed-loop fluid distribution arrangement **(134)** such that the channelized fluid having a higher temperature is cooled into channelized fluid having a lower temperature that is to be circulated by the closed-loop distribution arrangement (134), the external cooling module **(130)** comprising a fluidly-coupled input configured to receive the higher-temperature channelized fluid via the closed-loop fluid distribution arrangement **(134)** and a fluidly-coupled output configured to forward the cooled channelized fluid via the closed-loop fluid distribution arrangement **(134);**
the serpentine convection coil (120) fully submerged in a vertical orientation within the dielectric immersion cooling liquid and separately disposed from the at least one electronic assembly **(108),** the serpentine convection coil **(120)** comprising a plurality of hollow-channel coils to internally convey the cooled circulating channelized fluid, the serpentine convection coil (120) incorporating an upper port fluidly coupled to the closed-loop fluid distribution arrangement (134) and a lower port fluidly-coupled to the closed-loop fluid distribution arrangement (134); and
at least one fluid cooling block **(110A, 112A)** arranged to be in direct thermal contact with one or more submerged heat-generating electronic processing components **(110, 112),**at least one fluid cooling block **(110A, 112A)** fluidly-coupled to the closed-loop fluid distribution arrangement **(134)** and configured to cool the one or more heat-generating electronic processing components **(110, 112)** based on the cooled channelized fluid circulated by the cooling module **(130)** via the closed-loop fluid distribution arrangement **(134),**
wherein the tube channel network (136) of the closed-loop fluid distribution arrangement (134) is configured to circulate the channelized fluid by serially connecting the fluid-coupled vertically oriented serpentine (120), the fluidly-coupled at least one cooling block (110A, 112A), and the fluidly-coupled external cooling module (130) and to operate in the following alternative arrangements:
(a) forward the lower-temperature channelized fluid from the external cooling module **(130)** to the fluidly-coupled serpentine convection coil **(120)** or to the fluidly-coupled one or more fluid cooling blocks **(110A, 112A)** for cooling operations, and
(b) return the higher-temperature channelized fluid from the fluidly-coupled one or more fluid cooling blocks **(110A, 112A)** or from the fluidly-coupled vertically oriented serpentine convection coil (120) back to the external cooling module **(130)** for conditioning into the lower-temperature channelized fluid.

2. The rack-mounted hybrid liquid cooling system **(100)** of claim 1, further comprising an external cooling source **(132)** configured to provide lower temperature fluid flow to the external cooling module **(130)** to facilitate the thermal conditioning by the external cooling module **(130)** of the higher-temperature channelized fluid into the lower-temperature channelized fluid.

3. The rack-mounted hybrid liquid cooling system **(100)** of claim 2, wherein the external cooling source **(132)** comprises a dry cooling unit configured to provide lower temperature air flow to the external cooling module **(130).**

4. The rack-mounted hybrid liquid cooling system **(100)** of claim 1, further comprising at least one pump **(140)** fluidly-coupled to the external cooling module **(130)** and the tube channel network **(136)** and configured to urge the flow of the circulating channelized fluid through the closed-loop fluid distribution arrangement **(134).**

5. The rack-mounted hybrid liquid cooling system (100) of claim 1, wherein the one or more one heat-generating electronic processing components (110, 112) comprise general processing units and/or specialized processing units.

6. The rack-mounted hybrid liquid cooling system **(100)** of claim 1, wherein the at least one electronic assembly **(108)** comprises one or more random access memory units and/or one or more hard disk storage units.

7. The rack-mounted hybrid liquid cooling system **(100)** of claim 1, wherein the vertically-oriented serpentine convection coil **(120)** is positioned relative proximate to locations of the one or more heat-generating electronic processing components **(110, 112)** disposed on the at least one electronic assembly **(108).**

8. The rack-mounted hybrid liquid cooling system **(100)** of claim 1, wherein the tube channel network **(136)** is structured to:
route the lower-temperature channelized fluid from the external cooling module (130) to at least one fluid cooling block (110A); and
route a resulting higher-temperature channelized fluid output from the at least one cooling block **(110A)** to the upper port of the vertically-oriented serpentine convection coil **(120),**
wherein the lower port of the vertically-oriented serpentine convection coil **(120)** forwards the higher-temperature channelized fluid to the external cooling module **(130)** for thermal conditioning into the lower-temperature channelized fluid.

9. The rack-mounted hybrid liquid cooling system **(100)** of claim 1, wherein the tube channel network **(136)** is structured to:
route the lower-temperature channelized fluid from the external cooling module (130) to at least one fluid cooling block (110A); and
route a resulting higher-temperature channelized fluid output from the at least one fluid cooling block **(110A)** to the lower port of the vertically-oriented serpentine convection coil **(120),**
wherein the upper port of the vertically-oriented serpentine convection coil **(120)** forwards the higher-temperature channelized fluid to the external cooling module **(130)** for thermal conditioning into the lower-temperature channelized fluid.

10. The rack-mounted hybrid liquid cooling system **(100)** of claim 1, wherein the tube channel network **(136)** is structured to:
route the lower-temperature channelized fluid from the external cooling module (130) to the lower port of the vertically-oriented serpentine convection coil (120); and
route the lower-temperature channelized fluid from the upper port of the vertically-oriented serpentine convection coil (120) to at least one fluid cooling block (110A),
wherein a resulting higher-temperature channelized fluid output from the at least one fluid cooling block (110A) is forwarded to the external cooling module (130) for thermal conditioning into the lower-temperature channelized fluid.

11. The rack-mounted hybrid liquid cooling system (100) of claim 1, wherein the tube channel network (136) is structured to:
route the lower-temperature channelized fluid from the external cooling module (130) to the upper port of the vertically-oriented serpentine convection coil (120); and
route the lower-temperature channelized fluid from the lower portion port of the vertically-oriented serpentine convection coil (120) to at least one fluid cooling block (110A),
wherein a resulting higher-temperature channelized fluid output from the at least one fluid cooling block (110A) is forwarded to the external cooling module (130) for thermal conditioning into the lower-temperature channelized fluid.

12. The rack-mounted hybrid liquid cooling system (100) of claim 1, wherein the at least one at least one fluid cooling block (110A) comprises a first fluid cooling block (110A) and a second fluid cooling block (112A) that are fluidly-coupled in series with each other.

## Patentansprüche

1. Rackmontiertes hybrides Flüssigkeitskühlsystem **(100),** umfassend mindestens ein Tauchgehäuse **(104),** das an einem Rackrahmen (102) montiert ist und ein Volumen an dielektrischer Tauchkühlflüssigkeit **(106)** enthält, und mindestens eine elektronische Baugruppe **(108),** umfassend eine oder mehrere wärmeerzeugende elektronische Verarbeitungskomponenten **(110, 112),** die in die dielektrische Tauchkühlflüssigkeit eingetaucht sind **(106);**
eine geschlossene Fluid-Verteilungsanordnung (134), die so konfiguriert ist, dass sie ein kanalisiertes Fluid zu und von einer Serpentinen-Konvektionsspule (120) zirkuliert, die in die dielektrische Tauchkühlflüssigkeit und einen oder mehrere Fluid-Kühlblöcke **(110A, 112A)** in direkten thermischen Kontakt mit den benannten wärmeerzeugenden elektronischen Verarbeitungskomponenten **(110, 112)** zu bringen, die in das rackmontierte Tauchgehäuse (104) eingetaucht sind, die geschlossene Fluid-Verteilungsanordnung (134) ein Rohrkanalnetzwerk (136) umfassend;
ein externes Kühlmodul (130), das so konfiguriert ist, dass es das durch die geschlossene Fluid-Verteilungsanordnung **(134)** zirkulierte kanalisierte Fluid derart thermisch konditioniert, dass das kanalisierte Fluid mit einer höheren Temperatur zu einem kanalisierten Fluid mit einer niedrigeren Temperatur gekühlt wird, das durch die geschlossene Verteilungsanordnung (134) zirkuliert werden soll, das externe Kühlmodul **(130)** umfassend einen fluidisch gekoppelten Eingang, der konfiguriert ist, um das kanalisierte Fluid mit höherer Temperatur über die geschlossene Fluid-Verteilungsanordnung **(134)** aufzunehmen, und einen fluidisch gekoppelten Ausgang, der konfiguriert ist, um das gekühlte kanalisierte Fluid über die geschlossene Fluid-Verteilungsanordnung **(134)** weiterzuleiten;
die Serpentinen-Konvektionsspule (120), die vollständig in einer vertikalen Ausrichtung in die dielektrische Tauchkühlflüssigkeit eingetaucht und separat von der mindestens einen elektronischen Baugruppe **(108)** angeordnet ist, die Serpentinen-Konvektionsspule **(120)** umfassend eine Vielzahl von Hohlkanalspulen, um das gekühlte zirkulierende kanalisierte Fluid intern zu transportieren, wobei die Serpentinen-Konvektionsspule (120) einen oberen Anschluss, der fluidisch mit der geschlossenen Fluid-Verteilungsanordnung (134) gekoppelt ist, und einen unteren Anschluss, der fluidisch mit der geschlossenen Fluid-Verteilungsanordnung (134) gekoppelt ist, beinhaltet; und
mindestens einen Fluid-Kühlblock **(110A, 112A),** der so angeordnet ist, dass er in direktem thermischen Kontakt mit einer oder mehreren eingetauchten wärmeerzeugenden elektronischen Verarbeitungskomponenten **(110, 112)** steht, mindestens einen Fluid-Kühlblock **(110A, 112A),** der fluidisch mit der geschlossenen Fluid-Verteilungsanordnung **(134)** gekoppelt und so konfiguriert ist, dass er die eine oder mehrere wärmeerzeugende elektronischen Verarbeitungskomponenten **(110, 112)** auf der Grundlage des gekühlten kanalisierten Fluids kühlt, das von dem Kühlmodul **(130)** über die geschlossene Fluid-Verteilungsanordnung **(134)** zirkuliert wird,
wobei das Rohrkanalnetzwerk (136) der geschlossenen Fluid-Verteilungsanordnung (134) so konfiguriert ist, dass es das kanalisierte Fluid zirkuliert, indem es die fluidgekoppelte, vertikal ausgerichtete Serpentine (120), den fluidisch gekoppelten mindestens einen Kühlblock (110A, 112A) und das fluidisch gekoppelte externe Kühlmodul (130) in Reihe verbindet und in den folgenden alternativen Anordnungen betreibt:
(a) Weiterleiten des auf niedrigerer Temperatur kanalisierten Fluids von dem externen Kühlmodul **(130)** zu der fluidisch gekoppelten Serpentinen-Konvektionsspule **(120)** oder zu dem fluidisch gekoppelten einen oder zu mehreren Fluid-Kühlblöcken **(110A, 112A)** für Kühlvorgänge, und
(b) Rückführen des kanalisierten Fluids mit höherer Temperatur aus dem fluidisch gekoppelten einen oder mehreren Fluid-Kühlblöcken **(110A, 112A)** oder aus der fluidisch gekoppelten vertikal ausgerichteten Serpentinen-Konvektionsspule (120) zurück zu dem externen Kühlmodul **(130),** um es in das kanalisierte Fluid mit niedrigerer Temperatur zu konditionieren.

2. Rackmontiertes hybrides Flüssigkeitskühlsystem **(100)** nach Anspruch 1, ferner umfassend eine externe Kühlquelle **(132),** die konfiguriert ist, um dem externen Kühlmodul **(130)** einen Fluidstrom mit niedrigerer Temperatur bereitzustellen, um die thermische Konditionierung des kanalisierten Fluids mit höherer Temperatur durch das externe Kühlmodul **(130)** zu einem kanalisierten Fluid mit niedrigerer Temperatur zu erleichtern.

3. Rackmontiertes hybrides Flüssigkeitskühlsystem **(100)** nach Anspruch 2, wobei die externe Kühlquelle **(132)** eine Trockenkühlungseinheit umfasst, die so konfiguriert ist, dass sie dem externen Kühlmodul **(130)** einen Luftstrom mit niedrigerer Temperatur bereitstellt.

4. Rackmontiertes hybrides Flüssigkeitskühlsystem **(100)** nach Anspruch 1, ferner umfassend mindestens eine Pumpe **(140),** die fluidisch mit dem externen Kühlmodul **(130)** und dem Rohrkanalnetzwerk **(136)** gekoppelt und so konfiguriert ist, dass sie den Strom des zirkulierenden kanalisierten Fluids durch die geschlossene Fluid-Verteilungsanordnung **(134)** treibt.

5. Rackmontiertes hybrides Flüssigkeitskühlsystem (100) nach Anspruch 1, wobei die eine oder mehreren wärmeerzeugenden elektronischen Verarbeitungskomponenten (110, 112) allgemeine Verarbeitungseinheiten und/oder spezialisierte Verarbeitungseinheiten umfassen.

6. Rackmontiertes hybrides Flüssigkeitskühlsystem **(100)** nach Anspruch 1, wobei die mindestens eine elektronische Baugruppe **(108)** eine oder mehrere Direktzugriffsspeichereinheiten und/oder eine oder mehrere Festplattenspeichereinheiten umfasst.

7. Rackmontiertes hybrides Flüssigkeitskühlsystem **(100)** nach Anspruch 1, wobei die vertikal ausgerichtete Serpentinen-Konvektionsspule **(120)** relativ nahe an den Stellen der einen oder mehreren wärmeerzeugenden elektronischen Verarbeitungskomponenten **(110, 112)** positioniert ist, die auf der mindestens einen elektronischen Baugruppe **(108)** angeordnet sind.

8. Rackmontiertes hybrides Flüssigkeitskühlsystem **(100)** nach Anspruch 1, wobei das Rohrkanalnetzwerk **(136)** strukturiert ist, um:
das kanalisierte Fluid mit niedrigerer Temperatur von dem externen Kühlmodul (130) zu mindestens einem Fluid-Kühlblock (110A) zu leiten; und
ein resultierendes, kanalisiertes Fluid mit höherer Temperatur aus dem mindestens einen Kühlblock **(110A)** zu dem oberen Anschluss der vertikal ausgerichteten Serpentinen-Konvektionsspule **(120)** zu leiten,
wobei der untere Anschluss der vertikal ausgerichteten Serpentinen-Konvektionsspule **(120)** das kanalisierte Fluid mit höherer Temperatur zu dem externen Kühlmodul **(130)** weiterleitet, um es thermisch zu konditionieren und in das kanalisierte Fluid mit niedrigerer Temperatur umzuwandeln.

9. Rackmontiertes hybrides Flüssigkeitskühlsystem **(100)** nach Anspruch 1, wobei das Rohrkanalnetzwerk **(136)** strukturiert ist, um:
das kanalisierte Fluid mit niedrigerer Temperatur von dem externen Kühlmodul (130) zu mindestens einem Fluid-Kühlblock (110A) zu leiten; und
ein resultierendes, kanalisiertes Fluid mit höherer Temperatur aus dem mindestens einen Fluid-Kühlblock **(110A)** zu dem unteren Anschluss der vertikal ausgerichteten Serpentinen-Konvektionsspule **(120)** zu leiten,
wobei der obere Anschluss der vertikal ausgerichteten Serpentinen-Konvektionsspule **(120)** das kanalisierte Fluid mit höherer Temperatur zu dem externen Kühlmodul **(130)** weiterleitet, um es thermisch zu konditionieren und in das kanalisierte Fluid mit niedrigerer Temperatur umzuwandeln.

10. Rackmontiertes hybrides Flüssigkeitskühlsystem **(100)** nach Anspruch 1, wobei das Rohrkanalnetzwerk **(136)** strukturiert ist, um:
das kanalisierte Fluid mit niedrigerer Temperatur von dem externen Kühlmodul (130) zu dem unteren Anschluss der vertikal ausgerichteten Serpentinen-Konvektionsspule (120) zu leiten; und
das kanalisierte Fluid mit niedrigerer Temperatur von dem oberen Anschluss der vertikal ausgerichteten Serpentinen-Konvektionsspule (120) zu mindestens einem Fluid-Kühlblock (110A) zu leiten,
wobei ein resultierender, kanalisierter Fluid-Ausgang mit höherer Temperatur aus dem mindestens einen Fluid-Kühlblock (110A) zu dem externen Kühlmodul (130) weitergeleitet wird, um thermisch in das kanalisierte Fluid mit niedrigerer Temperatur konditioniert zu werden.

11. Rackmontiertes hybrides Flüssigkeitskühlsystem (100) nach Anspruch 1, wobei das Rohrkanalnetzwerk (136) strukturiert ist, um:
das kanalisierte Fluid mit niedrigerer Temperatur von dem externen Kühlmodul (130) zu dem oberen Anschluss der vertikal ausgerichteten Serpentinen-Konvektionsspule (120) zu leiten; und
das kanalisierte Fluid mit niedrigerer Temperatur von dem unteren Abschnittsanschluss der vertikal ausgerichteten Serpentinen-Konvektionsspule (120) zu mindestens einem Fluid-Kühlblock (110A) zu leiten,
wobei ein resultierender, kanalisierter Fluid-Ausgang mit höherer Temperatur aus dem mindestens einen Fluid-Kühlblock (110A) zu dem externen Kühlmodul (130) weitergeleitet wird, um thermisch in das kanalisierte Fluid mit niedrigerer Temperatur konditioniert zu werden.

12. Rackmontiertes hybrides Flüssigkeitskühlsystem (100) nach Anspruch 1, wobei der mindestens eine Fluid-Kühlblock (110A) einen ersten Fluid-Kühlblock (110A) und einen zweiten Fluid-Kühlblock (112A) umfasst, die in Reihe miteinander fluidisch gekoppelt sind.

## Revendications

1. Système hybride de refroidissement par liquide monté sur bâti **(100),** comprenant au moins un boîtier d'immersion **(104)** monté sur un cadre de bâti (102) et contenant un volume de liquide de refroidissement par immersion diélectrique **(106)** et au moins un ensemble électronique **(108)** comprenant un ou plusieurs composants électroniques de traitement générateurs de chaleur **(110, 112)** immergés dans le liquide de refroidissement par immersion diélectrique **(106)** ;
un agencement de distribution de fluide en boucle fermée (134) configuré pour faire circuler un fluide canalisé vers et en provenance d'un serpentin plat à convection (120) immergé à l'intérieur du liquide de refroidissement par immersion diélectrique et un ou plusieurs blocs de refroidissement par fluide **(110A, 112A)** en contact thermique direct avec lesdits composants électroniques de traitement générateurs de chaleur **(110, 112)** immergés à l'intérieur du boîtier d'immersion monté sur bâti (104), l'agencement de distribution de fluide en boucle fermée (134) comprenant un réseau de canaux tubulaires (136) ;
un module de refroidissement externe (130) configuré pour conditionner thermiquement le fluide canalisé mis en circulation par l'agencement de distribution de fluide en boucle fermée **(134)** de telle sorte que le fluide canalisé ayant une température supérieure est refroidi en un fluide canalisé ayant une température inférieure qui doit être mis en circulation par l'agencement de distribution en boucle fermée (134), le module de refroidissement externe **(130)** comprenant une entrée accouplée fluidiquement configurée pour recevoir le fluide canalisé à température supérieure par l'intermédiaire de l'agencement de distribution de fluide en boucle fermée **(134)** et une sortie accouplée fluidiquement configurée pour transmettre le fluide canalisé refroidi par l'intermédiaire de l'agencement de distribution de fluide en boucle fermée **(134)** ;
le serpentin plat à convection (120) est entièrement immergé à la verticale dans le liquide de refroidissement par immersion diélectrique et est disposé séparément dudit au moins un ensemble électronique **(108),** le serpentin plat à convection **(120)** comprenant une pluralité de serpentins à canaux creux pour acheminer en leur sein le fluide canalisé en circulation refroidi, le serpentin plat à convection (120) comprenant un orifice supérieur accouplé fluidiquement à l'agencement de distribution de fluide en boucle fermée (134) et un orifice inférieur accouplé fluidiquement à l'agencement de distribution de fluide en boucle fermée (134) ; et
au moins un bloc de refroidissement par fluide **(110A, 112A)** agencé de sorte à être en contact thermique direct avec un ou plusieurs composants électroniques de traitement générateurs de chaleur immergés **(110, 112),** au moins un bloc de refroidissement par fluide **(110A, 112A)** accouplé fluidiquement à l'agencement de distribution de fluide en boucle fermée **(134)** et configuré pour refroidir le ou les composants électroniques de traitement générateurs de chaleur **(110, 112)** sur la base du fluide canalisé refroidi mis en circulation par le module de refroidissement **(130)** par l'intermédiaire de l'agencement de distribution de fluide en boucle fermée **(134),**
dans lequel le réseau de canaux tubulaires (136) de l'agencement de distribution de fluide en boucle fermée (134) est configuré pour faire circuler le fluide canalisé en reliant en série le serpentin orienté verticalement accouplé fluidiquement (120), l'au moins un bloc de refroidissement accouplé fluidiquement (110A, 112A) et le module de refroidissement externe accouplé fluidiquement (130) et pour fonctionner dans les agencements alternatifs suivants :
(a) transférer le fluide canalisé à température inférieure du module de refroidissement externe **(130)** au serpentin plat à convection accouplé fluidiquement **(120)** ou auxdits un ou plusieurs blocs de refroidissement par fluide accouplés fluidiquement **(110A, 112A)** pour les opérations de refroidissement, et
(b) renvoyer le fluide canalisé à température supérieure à partir desdits un ou plusieurs blocs de refroidissement par fluide accouplés fluidiquement **(110A, 112A)** ou à partir dudit serpentin plat à convection orienté verticalement accouplé fluidiquement (120) de nouveau vers le module de refroidissement externe **(130)** à des fins de conditionnement en fluide canalisé à température inférieure.

2. Système hybride de refroidissement par liquide monté sur bâti **(100)** selon la revendication 1, comprenant en outre une source de refroidissement externe **(132)** configurée pour fournir au module de refroidissement externe **(130)** un écoulement de fluide à température inférieure afin de faciliter le conditionnement thermique par le module de refroidissement externe **(130)** du fluide canalisé à température supérieure en fluide canalisé à température inférieure.

3. Système hybride de refroidissement par liquide monté sur bâti **(100)** selon la revendication 2, dans lequel la source de refroidissement externe **(132)** comprend une unité de refroidissement à sec configurée pour fournir un flux d'air à température inférieure au module de refroidissement externe **(130).**

4. Système hybride de refroidissement par liquide monté sur bâti **(100)** selon la revendication 1, comprenant en outre au moins une pompe **(140)** accouplée fluidiquement au module de refroidissement externe **(130)** et au réseau de canaux tubulaires **(136)** et configurée pour pousser l'écoulement du fluide canalisé en circulation à travers l'agencement de distribution de fluide en boucle fermée **(134).**

5. Système hybride de refroidissement par liquide monté sur bâti (100) selon la revendication 1, dans lequel le ou les composants électroniques de traitement générateurs de chaleur (110, 112) comprennent des unités de traitement générales et/ou des unités de traitement spécialisées.

6. Système hybride de refroidissement par liquide monté sur bâti **(100)** selon la revendication 1, dans lequel l'au moins un ensemble électronique **(108)** comprend une ou plusieurs unités de mémoire vive et/ou une ou plusieurs unités de stockage sur disque dur.

7. Système hybride de refroidissement par liquide monté sur bâti **(100)** selon la revendication 1, dans lequel le serpentin plat à convection orienté verticalement **(120)** est positionné relativement à proximité des emplacements du ou des composants électroniques de traitement générateurs de chaleur **(110, 112)** disposés sur l'au moins un ensemble électronique **(108).**

8. Système hybride de refroidissement par liquide monté sur bâti **(100)** selon la revendication 1, dans lequel le réseau de canaux tubulaires **(136)** est structuré de sorte à :
acheminer le fluide canalisé à température inférieure du module de refroidissement externe (130) vers au moins un bloc de refroidissement par fluide (110A) ; et
acheminer un fluide canalisé à température supérieure ainsi obtenu en sortie de l'au moins un bloc de refroidissement **(110A)** vers l'orifice supérieur du serpentin plat à convection orienté verticalement **(120),**
dans lequel l'orifice inférieur du serpentin plat à convection orienté verticlament **(120)** transfère le fluide canalisé à température supérieure au module de refroidissement externe **(130)** à des fins de conditionnement thermique en fluide canalisé à température inférieure.

9. Système hybride de refroidissement par liquide monté sur bâti **(100)** selon la revendication 1, dans lequel le réseau de canaux tubulaires **(136)** est structuré de sorte à :
acheminer le fluide canalisé à température inférieure du module de refroidissement externe (130) vers au moins un bloc de refroidissement par fluide (110A) ; et
acheminer un fluide canalisé à température supérieure ainsi obtenu en sortie de l'au moins un bloc de refroidissement par fluide **(110A)** vers l'orifice inférieur du serpentin plat à convection orienté verticalement **(120),**
dans lequel l'orifice supérieur du serpentin plat à convection orienté verticlament **(120)** transfère le fluide canalisé à température supérieure au module de refroidissement externe **(130)** à des fins de conditionnement thermique en fluide canalisé à température inférieure.

10. Système hybride de refroidissement par liquide monté sur bâti **(100)** selon la revendication 1, dans lequel le réseau de canaux tubulaires **(136)** est structuré de sorte à :
acheminer le fluide canalisé à température inférieure du module de refroidissement externe (130) vers l'orifice inférieur du serpentin plat à convection orienté verticalement (120) ; et
acheminer le fluide canalisé à température inférieure de l'orifice supérieur du serpentin plat à convection orienté verticalement (120) vers au moins un bloc de refroidissement par fluide (110A),
dans lequel un fluide canalisé à température supérieure ainsi obtenu en sortie de l'au moins un bloc de refroidissement par fluide (110A) est transféré au module de refroidissement externe (130) à des fins de conditionnement thermique en fluide canalisé à température inférieure.

11. Système hybride de refroidissement par liquide monté sur bâti (100) selon la revendication 1, dans lequel le réseau de canaux tubulaires (136) est structuré de sorte à :
acheminer le fluide canalisé à température inférieure du module de refroidissement externe (130) vers l'orifice supérieur du serpentin plat à convection orienté verticalement (120) ; et
acheminer le fluide canalisé à température inférieure de l'orifice de partie inférieure du serpentin plat à convection orienté verticalement (120) vers au moins un bloc de refroidissement par fluide (110A),
dans lequel un fluide canalisé à température supérieure ainsi obtenu en sortie de l'au moins un bloc de refroidissement par fluide (110A) est transféré au module de refroidissement externe (130) à des fins de conditionnement thermique en fluide canalisé à température inférieure.

12. Système hybride de refroidissement par liquide monté sur bâti (100) selon la revendication 1, dans lequel l'au moins un bloc de refroidissement par fluide (110A) comprend un premier bloc de refroidissement par fluide (110A) et un second bloc de refroidissement par fluide (112A) qui sont accouplés fluidiquement en série l'un avec l'autre.
